**Europäisches Patentamt**

**European Patent Office**

**Office européen des brevets**

(19)

(11) Numéro de publication: **0 051 505**
**B1**

## FASCICULE DE BREVET EUROPEEN

(12)

(45) Date de publication du fascicule du brevet: **13.04.83**

(21) Numéro de dépôt: **81401533.5**

(22) Date de dépôt: **02.10.81**

(51) Int. Cl.³: **H 01 L 31/12,**
H 01 L 31/10, H 01 L 33/00

(54) Transistor émetteur-récepteur de lumière pour télécommunications à l'alternat sur fibre optique.

(30) Priorité: **28.10.80 FR 8023015**

(43) Date de publication de la demande:
**12.05.82 Bulletin 82/19**

(45) Mention de la délivrance du brevet:
**13.04.83 Bulletin 83/15**

(84) Etats contractants désignés:
**DE GB NL**

(56) Documents cités:
**EP - A - 0 012 585**

(73) Titulaire: **THOMSON-CSF**
**173, Boulevard Haussmann**
**F-75379 Paris Cedex 08 (FR)**

(72) Inventeur: **Poulain, Pierre**
**THOMSON-CSF SCPI 173, bld Haussmann**
**F-75360 Paris Cedex 08 (FR)**
Inventeur: **de Cremoux, Baudouin**
**THOMSON-CSF SCPI 173, bld Haussmann**
**F-75360 Paris Cedex 08 (FR)**
Inventeur: **Hirtz, Pierre**
**THOMSON-CSF SCPI 173, bld Haussmann**
**F-75360 Paris Cedex 08 (FR)**

(74) Mandataire: **Giraud, Pierre et al,**
**THOMSON-CSF SCPI 173, Bld Haussmann**
**F-75379 Paris Cedex 08 (FR)**

Transistor émetteur-récepteur de lumière pour télécommunications à l'alternat sur fibre optique

L'invention concerne les composants optoélectroniques susceptibles de fonctionner alternativement en émetteur et en récepteur, et d'être couplés dans des conditions favorables à une fibre optique notamment à celles du type utilisé en télécommunications.

Les composants utilisés jusqu'alors comportent des diodes à double hétéro-structure, fonctionnant en diodes électroluminescentes sous polarisation directe de la jonction semiconductrice, et en photodiodes, éventuellement avec gain d'amplification, sous polarisation inverse. Une telle diode est, par exemple, dècrite dans FR—A—2 387 519.

Or de tels composants, à diodes, présentent des performances relativement modestes qui résultent d'un compromis entre les conditions de fonctionnement à l'émission et à la réception. Dans les structures utilisables en émetteur et en récepteur, on observe les inconvénients suivants:

— rendement relativement faible, ne dépassant pas 20%;

— temps de réponse de l'émetteur environ dix fois plus grand que celui de la même structure utilisée en récepteur;

— bruit d'avalanche limitant le gain d'amplification à 10.

L'invention tend à remédier à ces inconvénients, en utilisant une hétérostructure comportant un phototransistor.

Le transistor selon l'invention est du type comportant un substrat semiconducteur et une série de couches semiconductrices comprenant au moins une couche active située entre deux hétérojonctions tel que revendiqué dans la revendication 1.

l'invention sera mieux comprise, et d'autres caractéristiques apparaitront au moyen de la description qui suit, et des dessins qui l'accompagnent parmi lesquels:

la figure 1 représente une réalisation de l'invention;

la figure 2 représente une variante de réalisation de l'invention;

les figures 3 et 4 représentent les modes de branchement électrique du transistor selon l'invention, respectivement à l'émission et à la réception.

Le transistor selon l'invention peut être réalisé en utilisant des matériaux semiconducteurs:

— soit du type ternaire: Ga, Al, As;

— soit du type quaternaire: Ga, In, As, P.

Le substrat peut être du type n ou p, et le phototransistor du type npn ou pnp.

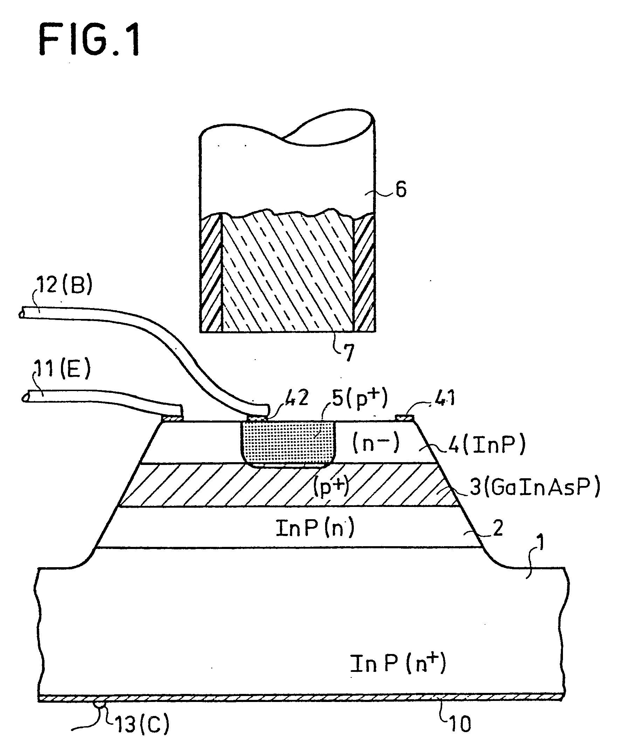

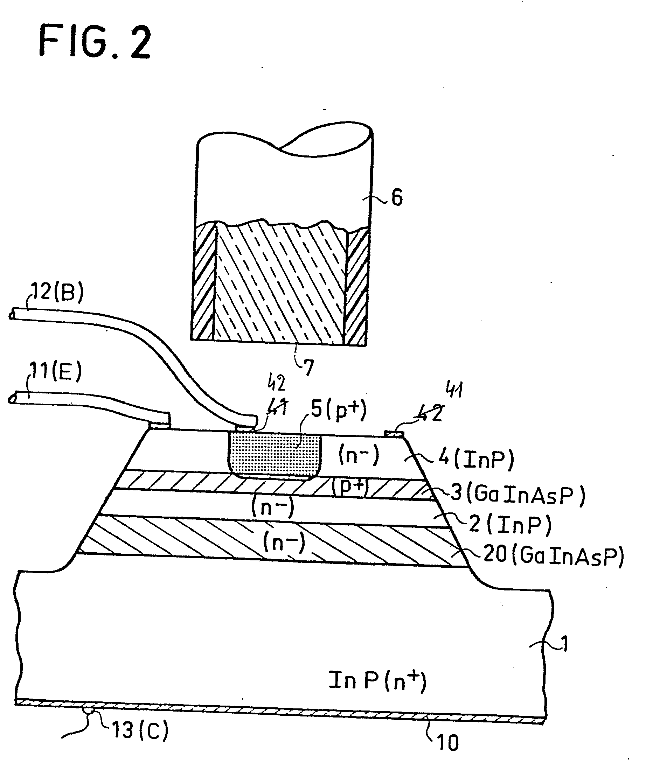

Les réalisations des figures 1 et 2 sont décrites pour un transistor npn dans le système quaternaire.

Sur la figure 1, on a représenté un substrat 1, en phosphure d'indium dopé $n^+$ (concentration supérieure ou égale à $10^{17}$ cm$^{-3}$). Des couches semiconductrices 2, 3 et 4 ont été déposées sur ce substrat et une gravure mésa de forme circulaire a été effectuée sur l'ensemble jusqu'au substrat 1, inclusivement.

La couche 2 est en phosphure d'indium dopé n avec une concentration moindre que celle du substrat soit de $10^{15}$ à $10^{16}$ cm$^{-3}$. Son épaisseur peut varier de 2 (cas du dopage maximal) à 20 microns (cas du dopage minimal). Cette épaisseur est calculée en fonction de la concentration et des tensions d'alimentation susceptibles de créer des champs électriques capables de mettre la totalité de la couche en régime de charge d'espace.

La couche 3 est en arséniure de gallium, d'indium et de phosphore, selon la formule générale:

$$Ga_x \, In_{1-x} \, As_y \, P_{1-y} \text{ (dopé } p^+)$$

avec $0 < x < 0,47$
et $0 < y < 1$

Les paramètres x et y sont choisis dans les intervalles ci-dessus de manière à satisfaire à la relation:

$$x = \frac{0,19 \, y}{0,42 - 0,13 \, y}$$

En effet, cette relation est la condition à réaliser pour que le réseau monocristlalin soit compatible avec celui du substrat 1 et de la couche 2. En pratique, il suffit qu'elle soit vérifiée à 1% près.

Le dopage $p^+$ est de l'ordre de $10^{18}$ cm$^{-3}$. L'épaisseur est de 1 à 2 microns.

A titre d'exemple, pour une longueur d'onde de la lumière émise par la couche 3 égale à 1,3 micron, on choisit:

x = 0,22
y = 0,5.

La couche 4 est en InP de type $n^-$ (concentration de $10^{16}$ cm$^{-3}$) d'une épaisseur de 1 à 3 microns.

On réalise une région 5, sensiblement cylindrique et placée au centre de la structure circulaire mésa. Elle présente un fort dopage $p^+$ (concentration supérieure à $10^{17}$ cm$^{-3}$) par l'emploi d'une méthode classique d'implantation ou de diffusion localisée d'impuretés de type p. En particulier, dans le cas de la diffusion, un masquage est nécessaire pour empêcher la diffusion d'impuretés en dehors de la région choisie (5).

Puis on réalise des contacts ohmiques 41 et 42. Le contact 41 est annulaire et situé à la périphérie de la surface libre de la couche 4. Le contact 42 est réalisé à la surface de la région 5.

On soude des connexions 11(E) et 12(B), respectivement sur les contacts 41 et 42 pour servir de connexions d'émetteur et de base. Une connexion 13(C) de collecteur est soudée à une métallisation 10 préalablement réalisée sur la face du substrat opposée aux couches 1 à 4.

On a représenté partiellement une fibre optique 6 dont le coeur présente une face plane 7.

La surface de la région 5 doit de préférence être inférieure à celle de la face plane d'entrée de la fibre, pour que l'émission lumineuse provenant de la couche 3, dans la région située en dessous de la région 5, pénètre essentiellement dans le coeur de la fibre. Dans ces conditions le fonctionnement à l'émission est favorable à une bonne transmission, et, en ce qui concerne les conditions de réception, il est souhaitable que la surface de la région 5 soit du même ordre que la face d'entrée de la fibre.

Le fonctionnement du transistor ainsi réalisé est le suivant:

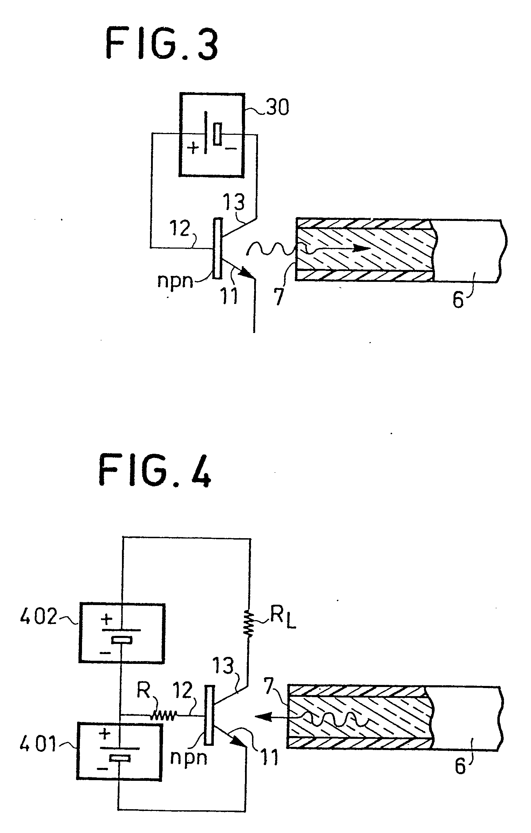

Si l'on polarise en direct (figure 3) la jonction pn du transistor npn en appliquant entre les connexions 12 et 13 un générateur 30 de tension continue, on observe une émission de photons dont l'origine est localisée dans la partie de la couche 3 la plus proche de la région 5. La connexion 11 (émetteur) est laissée "en l'air", son potentiel demeurant "flottant". En effet dans le fonctionnement en diode électroluminescente seule l'hétérojonction $p^+n$ entre couches 3 et 2 joue le rôle actif. Une particularité de cette structure réside dans la localisation du courant de trous provenant de la région 5 dans la partie de la couche 3 située entre cette région et la couche 2, ce qui produit à son tour une localisation des photons créés par suite de la rencontre des trous avec les électrons provenant de la couche 2.

Sur la figure 4 on a représenté un mode de branchement différent de celui de la figure 3 et qui correspond au caus du fonctionnement en phototransistor. Une source de tension continue 401 est connectée par son pôle — à l'émetteur 11 et par son pôle + à la base 12 à travers une résistance R. Une source de tension continue 402 est connectée par son pôle — au pôle + de la source 401 et par son pôle + au collecteur 13 à travers un récepteur $R_L$. Les photons absorbés dans la couche 3 donnent naissance à des paires d'électrons et de trous qui génèrent le courant primaire. Ce courant est amplifié par effet transistor et donnent naissance à un courant collecteur qui traverse le récepteur $R_L$ qui joue le rôle de détecteur de courant photonique.

La figure 2 représente une variante de la réalisation de la figure 1. Les mêmes références désignent les mêmes éléments. La structure semiconductrice de cette variante diffère de la précédente par la présence d'une couche supplémentaire 20 et par une épaisseur différente de la couche 3, ici beaucoup plus mince (0,2 à 0,5 micron).

La couche 20 est une couche d'absorption des photons, dont la bande interdite est à dessein plus étroite que celle de la couche 3. A cet effet on a choisi pour la couche 20 la composition:

$$Ga_{x'} In_{1-x'} As_{y'} P_{1-y'} \text{ (dopé } n^-)$$

avec par exemple:

$x' = 0,26$
$y' = 0,60$

et de façon plus générale $x'$ et $y'$ obéissant aux mêmes relations que $x$ et $y$ tout en étant respectivement plus grands que les paramètres correspondants de la couche 3.

Le dopage présente une concentration d'atomes $n^-$ de $10^{15}$ à $10^{16}$ cm$^{-3}$.

La couche 2 est de même nature et de même dopage que dans la structure de la figure 1. Toutefois son épaisseur est notablement plus petite, comprise entre 0,1 et 0,3 micron.

Le reste du dispositif est le même pour les deux réalisations. Le fonctionnement est analogue et les circuits d'utilisation identiques. La seule différence provient de la séparation des couches d'émission et de détection photonique, dans la deuxième réalisation.

Dans le cas de l'utilisation de matériaux du type ternaire (Ga, Al, As) les compositions seraient les suivantes:

1°/Dans la réalisation de la figure 1:
Substrat 1: Ga As
Couche 2: $Ga_{1-x} Al_x$ As avec $0,2 \leq x \leq 0,4$
Couche 3: formule analogue avec $0 \leq x \leq 0,1$
Couche 4: même composition que la couche 2 et même type de conductivité.

2°/Dans la réalisation de la figure 2:
Substrat 1: Ga As
Couche 20: Ga As
Couche 2: $Ga_{1-x} Al_x$ As avec $0,2 \leq x \leq 0,4$
Couche 3: formule analogue avec $0,02 \leq x \leq 0,1$ et de préférence : $x=0,05$
Couche 4: même composition que la couche 2.

L'invention s'applique à des transistors du type inverse, soit pnp, au lieu du type npn de la description qui précède, à condition de changer les polarités des tensions appliquées aux dispositifs.

**Revendications**

1. Transistor émetteur-récepteur de lumière, du type comportant un substrat semiconducteur et une série de couches semiconductrices comprenant au moins une couche active située entre deux hétérojonctions, caractérisé en ce que la couche (4) la plus éloignée du substrat destinée à être couplée à une face d'entrée ou de sortie d'une fibre optique (6) comporte une région (5) fortement dopée, du même type de conductivité que la couche active (3), et de type opposé à celui de la couche (4) au travers de laquelle la region (5) s'étend, et n'occupant qu'une partie de ladite couche active et raccordée à l'électrode de base (12) du transistor, la couche active (3) jouant le rôle de base dudit transistor, la couche (4) la plus éloignée du substrat le rôle d'émetteur et le substrat jouant le rôle de collecteur.

2. Transistor selon la revendication 1, caractérisé en ce que, le substrat étant en InP fortement dopé, d'un premier type de conductivité, une première couche (2) est en InP moins fortement dopé que le substrat dans le même type de conductivité, la deuxième couche ou couche active (3) étant en matériau du type opposé de conductivité et de formule:

$$Ga_x \ In_{1-x} \ As_y \ P_{1-y}$$

avec: $0 < x < 0,47$
$0 < y < 1$

où x et y sont liés entre eux de telle manière que les réseaux cristallins du substrat et des différentes couches soient compatibles, la troisième couche (4) ou couche la plus éloignée du substrat étant en InP de même type de conductivité que la première couche (2).

3. Transistor selon la revendication 1, caractérisé en ce que, le substrat étant en InP fortement dopé, d'un premier type de conductivité, il est prevu une première couche supplémentaire (20) en un matériau moins fortement dopé que le substrat, du même type de conductivité, mais de formule:

$$Ga_{x'} \ In_{1-y'} \ As_{y'} \ P_{1-y'}$$

avec: $0 < x' < 0,47$
$0 < y' < 1$

et de plus:

$x < x'$
$y < y'$

de telle soite que la Bande interdite de la couche (20) soit plus étroite que celle de la couche (3), les paramètres x' et y' d'une part, x et y d'autre part étant liés entre eux de telle manière que les réseaux cristallins du substrat et des différentes couches soient compatibles, une quatrième couche (4), constituant la couche la plus éloignée du substrat, ayant la même composition et le même type de conductivité que la deuxième couche.

4. Transistor selon la revendication 1, caractérisé en ce que, le substrat étant en GaAs fortement dopé, d'un premier type de conductivité, une première couche (2) est en $Ga_{1-x} \ Al_x \ As$ (avec $0,2 \le x \le 0,4$) moins fortement dopé que le substrat dans le même type de conductivité, la deuxième couche ou couche active (3) est en matériau de type opposé de conductivité et de formule:

$$Ga_{1-x} \ Al_x \ As$$

avec $0 \le x \le 0,1$, la troisième couche (4) ayant la même composition et le même type de conductivité que la première couche (2).

5. Transistor selon la revendication 1, caractérisé en ce que, le substrat étant en Ga As fortement dopé, d'un premier type de conductivité, une première couche (20) est en GaAs moins fortement dopé que le substrat, du même type de conductivité, une deuxième couche (2) étant en matériau de même type de conductivité que la première couche et de formule:

$$Ga_{1-x} \ Al_x \ As$$

avec $0,2 \le x \le 0,4$

une troisième couche ou couche active (3) étant en matériau de type de conductivité opposé, de composition analogue à celle de la deuxième couche (2) avec:

$$0,02 \le x \le 0,1$$

une quatrième couche (4) constituant la couche la plus éloignée du substrat ayant la même composition et le même type de conductivité que la deuxième couche (2).

6. Transistor selon la revendication 1, caractérisé en ce qu'il présente une structure mésa de forme circulaire, la région (5) fortement dopée étant implantée ou diffusée au centre de cette structure de manière à présenter une forme cylindrique.

**Patentansprüche**

1. Licht-Sende-Empfangs-Transistor mit einer Halbleiterträgerschicht und einer Mehrzahl von Halbleiterschichten, die wenigstens eine zwischen zwei Heteroverbindungsstellen angeordnete aktive Schicht umfassen, dadurch gekennzeichnet, dass die von der Trägerschicht am weitesten entfernte, zum Ankoppeln an eine Eingangsfläche bzw. Ausgangsfläche eines Lichtleiters (6) bestimmte Schicht (4) eine stark dotierte Zone (5) besitzt, die den gleichen Leitungsfähigkeitstyp wie die aktive Schicht (3) und den dem Leitfähigkeitstyp der von dieser Zone (5) durchdrungenen Schicht (4) entgegengesetzten Leitfähigkeitstyp aufweist, wobei diese Zone mit der Basiselektrode (12) des Transistors verbunden ist, und wobei die aktive Schicht (3) als Emitterelektrode und die Trägerschicht als Kollektorelektrode wirkt.

2. Transistor nach Anspruch 1, dadurch gekennzeichnet, dass die Trägerschicht eine mit einem ersten Leitfähigkeitstyp stark dotierte InP-Schicht ist, während eine erste Schicht (2) eine mit dem gleichen Leitfähigkeitstyp weniger stark als die Trägerschicht dotierte InP-Schicht ist und die zweite oder aktive Schicht (3) aus einem Material mit dem entgegengesetzten Leitfähigkeitstyp besteht, das der Formel

$$Ga_xIn_{1-x}As_yP_{1-y} \text{ entspricht,}$$

worin $0 < x < 0,47$
$0 < y < 1$

und worin x und y derart zusammenhängen, dass die Kristallgitter der Trägerschicht und der verschiedenen Schichten miteinander verträglich sind, und wobei die dritte oder von der Trägerschicht am weiteste, entfernte Schicht (4) eine InP-Schicht mit dem gleichen Leitfähigkeitstyp wie die erste Schicht (2) ist.

3. Transistor nach Anspruch 1, dadurch gekennzeichnet, dass die Trägerschicht eine mit einem ersten Leitfähigkeitstyp stark dotierte InP-Schicht ist und eine erste zusätzliche Schicht (20) vorgesehen ist, deren Material mit dem gleiche Leitfähigkeitstyp weniger stark als die Trägerschicht dotiert ist, jedoch der Formel

$$Ga_xIn_{1-y'}As_{y'}P_{1-y'} \text{ entspricht,}$$

worin $0 < x' < 0,47$
$0 < y' < 1$

ferner $x < x'$
$y < y'$

derart, dass das gesperrte Band der Schicht (20) schmaler ist, als dasjenigte der Schicht (3), wobei die Parameter x' und y' einerseite und x und y andererseits derart zusammenhängen, dass die Kristallgitter der Trägerschicht und der verschiedenen Schicht miteinander verträglich sind, und wobei eine die von der Trägerschicht am weitesten entfernte vierte Schicht (4) die gleiche Zusammensetzung und den gleichen Leitfähigkeitstyp aufweist wie die zweite Schicht.

4. Transistor nach Anspruch 1, dadurch gekennzeichnet, dass die Trägerschicht aus mit einemm ersten Leitfähigkeitstyp stark dotiertem GaAs besteht und eine erste Schicht mit dem gleichem Leitfähigkeitstyp weniger stark als die Trägerschicht dotiertem $Ga_{1-x}Al_xAs$ (worin $0,2 \le x \le 0,4$) besteht, während die zweite oder aktive Schicht (3) aus einem und mit der Formel entsprechenden Material mit entgegengesetztem Leitfähigkeitstyp

$$Ga_{1-x}Al_xAs \text{ besteht,}$$

worin $0 \le x \le 0,1$, und wobei die dritte Schicht die gleiche Zusammensetzung und den gleichen Leitfähigkeitstyp aufweit wie die erste Schicht (2).

5. Transistor nach Anspruch 1, dadurch gekennzeichnet, dass die Trägerschicht aus einem ersten Leitfähigkeitstyp stark dotiertem GaAs besteht, während eine erste Schicht (20) aus mit dem gleichen Leitfähigkeitstyp weniger stark als die Trägerschicht dotiertem Material der Formel

$$Ga_{1-x}Al_xAs \text{ besteht,}$$

worin $0,2 \le x \le 0,4$,

wobei eine dritte oder aktive Schicht (3) aus einem Material mit dem entgegengesetzten Leitfähigkeitstyp und einer der Formel der zweiten Schicht (20) entsprechenden Zusammensetzung besteht, worin

$$0,02 \le x \le 0,1$$

und wobei eine die von der Trägerschicht am weitesten entfernte vierte Schicht (4) den gleichen Leitfähigkeitstyp und die gleiche Zusammensetzung wie die zweite Schicht (2) besitzt.

6. Transistor nach Anspruch 1, dadurch gekennzeichnet, dass er eine kreisförmige Mesastrukture aufweist, wobei die stark dotierte Zone im Mittelbereich dieser Struktur (5) derart eingepflanzt oder diffundiert ist, dass sie eine zylindrische Form besitzt.

**Claims**

1. A light transmitter/receiver transistor, of the type comprising a semiconductor substrate and a series of semiconducting layers, comprising at least one active layer situated between two heterojunctions, characterized by the fact that the layer (4) furthest from the substrate and which is to be connected to an input or output surface of an optical fibre (6) comprises a strongly doped region (5), with the same type of conductivity as the active layer (3), and the opposite type to that of the layer (4) through which the region (5) extends, connected to the transistor base electrode (12), the active layer (3) acting as the transistor base, the layer (4) furthest from the substrate acting as emitter, and the substrate acting as collector.

2. A transistor as defined in claim 1, characterized by the fact that the substrate is formed of strongly doped InP, with one type of conductivity, the first layer (2) is formed of less strongly doped InP than the substrate with the same type of conductivity, and the second layer, or active layer (3), is formed of a material with the opposite type of conductivity, with the formula:

$$Ga_xIn_{1-x}As_yP_{1-y}$$

where $0 < x < 0,47$
$0 < y < 1$

and where x and y are linked in such a way that the crystal lattices of the substrate and various layers are compatible, the third layer (4), furthest from the substrate, being formed of InP with the same type of conductivity as the first layer (2).

3. A transistor as defined in claim 1, characterized by the fact that the substrate is formed of strongly doped InP, with one type of conductivity, and an additional first layer (20) is included, formed of a material less strongly doped than the substrate, with the same type of conductivity, but with the formula:

$$Ga_{x'}In_{1-y'}P_{1-y'}$$

where $0 < x' < 0.47$
$0 < y' < 1$

and $x < x'$
$y < y'$

so that the forbidden band of the layer (20) is narrower than that of layer (3), the parameters $x'$ and $y'$ on the one hand, and $x$ and $y$ on the other hand, being related in such a way that the crystal lattices of the substrate and various layers are compatible, a fourth layer (4) forming the layer furthest from the substrate, with the same composition and type of conductivity as the second layer.

4. A transistor as defined in claim 1, characterized by the fact that the substrate is formed of strongly doped GaAs, with one type of conductivity, a first layer (2) is formed of $Ga_{1-x}Al_xAs$ (where $0.2 \leq x \leq 0.4$), less strongly doped than the substrate with the same type of conductivity, the second layer, or active layer (3), is formed of a material with the opposite type of conductivity, and with the formula:

$$Ga_{1-x}Al_xAs$$

where $0 \leq x \leq 0.1$, the third layer (4) with the same composition and type of conductivity as the first layer (2).

5. A transistor as defined in claim 1, characterized by the fact that the substrate is formed of strongly doped GaAs, with one type of conductivity, a first layer (20) is formed of less strongly doped GaAs than the substrate, with the same type of conductivity, a second layer (2) is formed of a material with the same type of conductivity as the first layer, and with the formula:

$$Ga_{1-x}Al_xAs$$

where $0.2 \leq x \leq 0.4$

a third layer, or active layer (3), is formed of a material with the opposite type of conductivity, and with a composition similar to that of the second layer (2) where:

$$0.02 \leq x \leq 0.1$$

and a fourth layer (4), forming the layer furthest from the substrate, having the same composition and type of conductivity as the second layer (2).

6. A transistor as defined in claim 1, characterized by the fact that it possesses a circular mesa structure, the strongly doped region (5) being implanted or diffused in the centre of this structure, so as to be cylindrical in form.

# FIG.1

# FIG. 2

6

7

12(B)

11(E)

42
41

5(p+)

(n−)

41

42
41

4(InP)

(p+)

3(GaInAsP)

(n−)

2(InP)

(n−)

20(GaInAsP)

1

InP(n+)

13(C)

10

# FIG.3

# FIG.4